# EUROPEAN PATENT APPLICATION

(11) **EP 4 071 843 A1**
(43) Date of publication of application: **12.10.2022**
(21) Application number: 20909451.5
(22) Date of filing: 30.12.2020
(51) Int. Cl.: H01L 51/56, H01L 51/00, G03F 7/12, C23C 16/04

(54) **FLEXIBLE PHOTO-PATTERN MASK FOR ORGANIC LIGHT-EMITTING DISPLAY WITH HIGH RESOLUTION, AND METHOD FOR MANUFACTURING SAME**

(30) Priority: 03.01.2020 KR 20200000964
(71) Applicant: Hunetplus Co., Ltd., Chungcheongnam-do 31075 (KR)
(72) Inventor: CHA, Hyuk Jin, Seoul 06191 (KR); RYU, Mi Sun, Daejeon 35227 (KR)
(74) Representative: Prüfer & Partner mbB Patentanwälte · Rechtsanwälte
(86) International application number: PCT/KR2020/019391
(87) International publication number: WO 2021/137616

(57) **Abstract**

The present invention relates to a method for manufacturing a flexible photo-patterned mask. The method includes a) coating a photoresist composition on a substrate to form a photoresist film, b) exposing the photoresist film to pattern the photoresist film, c) developing the patterned photoresist film, and d) curing the developed photoresist film to form a patterned layer having a plurality of tapered openings.

## Description

### Technical Field

The present invention relates to a flexible photo-patterned mask for use in fabricating an organic light emitting display with high resolution and a method for manufacturing the photo-patterned mask.

### Background Art

Remarkable progress has been made in the field of flat panel displays. Flat panel displays, particularly liquid crystal displays (LCDs) in the lead, have begun to appear on the market and overtaken cathode ray tubes (CRTs). In recent years, display devices such as plasma display panel (PDP), visual fluorescent display (VFD), field emission display (FED), light emitting diode (LED), and electroluminescence (EL) devices have been fiercely competing and their improvements have been made in terms of visibility, color representation, and fabrication processing.

Organic light emitting displays (OLEDs) have attracted attention as flat panel displays due to their small space occupation. Other advantages are that organic light emitting displays are very small in thickness, are addressable in a matrix format, and can be driven even at a low voltage of 15 V or less.

A metal mask is usually used to form areas where an organic light emitting material is to be deposited and a second electrode in the fabrication of an organic light emitting display. Particularly, a metal mask is used to form RGB pixels in the fabrication of a full-color organic light emitting display. The pattern resolution of the metal mask determines the resolution of the organic light emitting display. Thus, the resolution of the metal mask needs to be improved. The metal mask should also be well aligned with a substrate.

According to the prior art, a metal mask is manufactured by applying a photoresist (PR) to a metal sheet, exposing the photoresist through a mask (or directly patterning without a mask using an exposure device), developing the exposed photoresist to form a pattern, and wet etching the pattern to transfer the pattern to the metal sheet.

However, the width of the pattern is hard to precisely control during the wet etching due to the isotropy of the etching, limiting the pattern resolution of the metal mask. Thus, techniques using electroplating instead of wet etching have been proposed to manufacture metal masks with high-resolution patterns.

Electroplating enables the manufacture of a metal mask with a high-resolution pattern but has a problem in that it is difficult to control the inclination of the side walls of patterned openings formed in the metal mask, resulting in non-uniform deposition of an organic light emitting material. Specifically, when the inclination of the side walls of the patterned openings of the metal mask is excessively vertical, some areas of the lower portions of the openings are shaded by the side walls of the openings. This shading impedes smooth supply of an organic light emitting material to some areas of the lower portions of the openings during deposition of the organic light emitting material using the metal mask, leading to non-uniform deposition of the organic light emitting material on a substrate. In an organic light emitting display in which an organic light emitting material is not uniformly deposited, a high-precision pixel pattern is not formed, leading to poor image quality and eventually failing to achieve high resolution.

### Detailed Description of the Invention

### Problems to be Solved by the Invention

Thus, the present invention intends to provide a flexible photo-patterned mask that can replace a conventional metal mask used in a process for depositing an organic light emitting material.

The present invention also intends to provide a method for manufacturing the flexible photo-patterned mask.

The present invention also intends to provide a method for depositing an organic light emitting material using the flexible photo-patterned mask.

### Means for Solving the Problems

One aspect of the present invention provides a method for manufacturing a flexible photo-patterned mask, including a) coating a photoresist composition on a substrate to form a photoresist film, b) exposing the photoresist film to pattern the photoresist film, c) developing the patterned photoresist film, and d) curing the developed photoresist film to form a patterned layer having a plurality of tapered openings.

The photoresist composition may be a positive type one including: at least one resin selected from the group consisting of acrylic resins, imide resins, cardo resins, and silicone resins; a photoactive material; an additive; and a solvent.

The photoresist composition may be a negative type one including: at least one resin selected from the group consisting of acrylic resins, imide resins, cardo resins, and silicone resins; a photocurable material; a photoinitiator; an additive; and a solvent.

The method of the present invention may further include repeating steps a) to d) one or more times to form a plurality of patterned layers, each of which has a plurality of tapered openings.

The method of the present invention may further include forming metal layers either or both on and under the patterned layer.

The tapered openings may have a taper angle (θ) of 20° to 85°.

The present invention also provides a flexible photo-patterned mask including a patterned layer having a plurality of tapered openings.

The tapered openings may have a taper angle (θ) of 20° to 85°.

The patterned layer may be provided in plurality.

The patterned layer may include a first patterned layer having tapered openings and a second patterned layer having tapered openings, the tapered openings of the first patterned layer may have a taper angle (θ₁) of 20° to 85°, and the tapered openings of the second patterned layer may have a taper angle (θ₂) of 30° to 85°.

The patterned layer may include a first patterned layer having tapered openings, a second patterned layer having tapered openings, and a third patterned layer having tapered openings, the tapered openings of the first patterned layer may have a taper angle (θ₁) of 20° to 85°, the tapered openings of the second patterned layer may have a taper angle (θ₂) of 30° to 85°, and the tapered openings of the third patterned layer may have a taper angle (θ₃) of 45° to 90°.

The flexible photo-patterned mask of the present invention may further include metal layers formed either or both on and under the patterned layer.

The present invention also provides a method for depositing an organic light emitting material, including A) aligning a flexible photo-patterned mask including a patterned layer having a plurality of tapered openings on a substrate for an organic light emitting display and B) depositing an organic light emitting material on the substrate through the plurality of tapered openings wherein the plurality of tapered openings become smaller in width as they approach the substrate.

### Effects of the Invention

The flexible photo-patterned mask of present invention is designed such that the width and/or taper angle of the patterned openings corresponding to areas where an organic light emitting material is to be deposited can be adjusted. This design prevents some areas of the lower portions of the patterned openings from being shaded by the side walls of the patterned openings of the flexible photo-patterned mask when an organic light emitting material is deposited using the flexible photo-patterned mask, enabling efficient deposition of the organic light emitting material on the target areas (pixel areas).

In addition, the flexible photo-patterned mask of the present invention is made of an organic material or an organic-inorganic material so that its shape can be well maintained during deposition. Therefore, the flexible photo-patterned mask of the present invention is stable in use compared to metal masks whose shape is not maintained for a long time.

Furthermore, the flexible photo-patterned mask of the present invention is simply manufactured by photolithography using a photoresist and is thus advantageous in terms of processing efficiency over conventional metal masks.

The use of the flexible photo-patterned mask according to the present invention enables the fabrication of an organic light emitting display with high resolution.

### Brief Description of the Drawings

FIG. 1 schematically illustrates a method for manufacturing a flexible photo-patterned mask according to one embodiment of the present invention.
FIG. 2 schematically illustrates a method for manufacturing a flexible photo-patterned mask according to a further embodiment of the present invention.
FIG. 3 is a cross-sectional view of a flexible photo-patterned mask according to one embodiment of the present invention.
FIGS. 4 to 6 are cross-sectional views of flexible photo-patterned mask according to exemplary embodiments of the present invention.
FIG. 7 schematically illustrates a method for depositing an organic light emitting material according to one embodiment of the present invention.

### Mode for Carrying out the Invention

It should be understood that the terms and words used in the specification and claims are not to be construed as having common and dictionary meanings, but are construed as having meanings and concepts corresponding to the spirit of the invention in view of the principle that the inventor can define properly the concept of the terms and words in order to describe his/her invention with the best method.

The present invention is directed to a flexible photo-patterned mask which is manufactured by photolithography and is designed such that the taper angle of patterned openings and the widths of upper and lower portions of the patterned openings can be adjusted. The flexible photo-patterned mask and a method for manufacturing the flexible photo-patterned mask according to the present invention will be described in detail with reference to the accompanying drawings.

The flexible photo-patterned mask of the present invention can be manufactured by photolithography. Specifically, the present invention provides a method for manufacturing the flexible photo-patterned mask, including a) coating a photoresist composition on a substrate to form a photoresist film, b) exposing the photoresist film to pattern the photoresist film, c) developing the patterned photoresist film, and d) curing the developed photoresist film to form a patterned layer having a plurality of tapered openings.

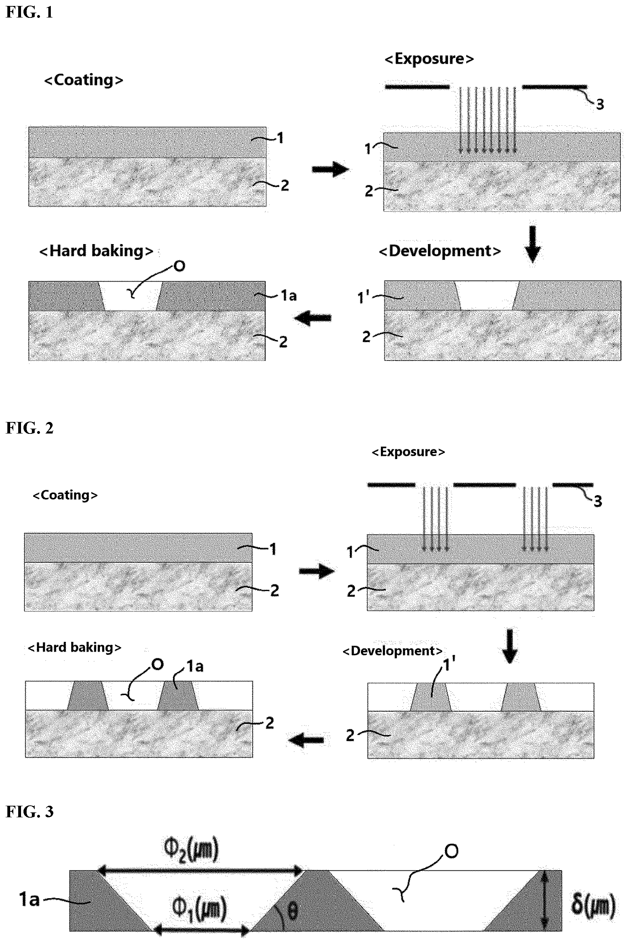

In step a), a photoresist film is formed using a photoresist composition. Depending on the type of the photoresist composition, the flexible photo-patterned mask may be manufactured by a process illustrated in FIG. 1 or FIG. 2. Specifically, FIG. 1 illustrates a case where the photoresist composition is of positive type and FIG. 2 illustrates a case where the photoresist composition is of negative type.

The positive type photoresist composition may include a resin, a photoactive material, an additive, and a solvent.

Specifically, the resin may be selected from the group consisting of acrylic resins, imide resins, cardo resins, silicone resins, and mixtures thereof. The resin may be a silicone resin (a polysiloxane copolymer) having a weight average molecular weight of 2,000 to 200,000 (specifically 2,000 to 100,000) and an acid value of 10 to 200 KOHmg/g (specifically 10 to 150 KOHmg/g). The use of the silicone resin facilitates the formation of tapered openings in the flexible photo-patterned mask.

The photoactive material refers to a material that reacts with light. The photoactive material is not particularly limited and may be any of those commonly known in the field of resists. Specifically, the photoactive material may be selected from the group consisting of photoacid compounds (PACs), photoacid generators (PAGs), photobase generators (PBGs), and mixtures thereof.

The additive is not particularly limited and may be any of those commonly known in the art. Specifically, the additive may be selected from the group consisting of crosslinkers, surfactants, adhesion aids, photosensitizers, heat stabilizers, photocuring accelerators, antioxidants, light stabilizers, defoamers, and mixtures thereof.

The solvent is not particularly limited and may be an organic solvent commonly known in the art. Specifically, the solvent may be selected from the group consisting of acetate-based solvents, ether-based solvents, glycol-based solvents, ketone-based solvents, alcohol-based solvents, carbonate-based solvents, and mixtures thereof.

The negative type photoresist composition may include a resin, a photocurable material, a photoinitiator, an additive, and a solvent.

Specifically, the resin may be selected from the group consisting of acrylic resins, imide resins, cardo resins, silicone resins, and mixtures thereof. The resin may be a silicone resin (a polysiloxane copolymer) having a weight average molecular weight of 2,000 to 200,000 (specifically 2,000 to 100,000) and an acid value of 10 to 200 KOHmg/g (specifically 10 to 150 KOHmg/g). The use of the silicone resin facilitates the formation of tapered openings in the flexible photo-patterned mask.

The photocurable material may be a photocurable compound having one or more ethylenically unsaturated bonds. Specifically, the photocurable material may be selected from the group consisting of: monomers, including ethylene glycol diacrylate, ethylene glycol dimethacrylate, diethylene glycol diacrylate, triethylene glycol diacrylate, triethylene glycol dimethacrylate, tetraethylene glycol diacrylate, tetraethylene glycol dimethacrylate, butylene glycol dimethacrylate, propylene glycol diacrylate, propylene glycol dimethacrylate, trimethylolpropane triacrylate, trimethylolpropane trimethacrylate, tetramethylolpropane tetraacrylate, tetramethylolpropane tetramethacrylate, pentaerythritol triacrylate, pentaerythritol trimethacrylate, pentaerythritol tetraacrylate, pentaerythritol tetramethacrylate, dipentaerythritol pentaacrylate, dipentaerythritol pentamethacrylate, dipentaerythritol hexaacrylate, dipentaerythritol hexamethacrylate, 1,6-hexanediol diacrylate, 1,6-hexanediol dimethacrylate, and cardo epoxy diacrylate; polyfunctional (meth)acrylic monomers, including poly-compounds (e.g., polyethylene glycol diacrylate) of the above monomers; oligomers of the above monomers; compounds other than the photocurable monomers having one or more ethylenically unsaturated bonds; and mixtures thereof.

The photoinitiator is not particularly limited and may be any of those commonly known in the art. Specifically, the photoinitiator may be selected from the group consisting of oxime ester compounds, biimidazole compounds, benzoin compounds, acetophenone compounds, benzophenone compounds, alpha-diketone compounds, polynuclear quinone compounds, phosphine compounds, triazine compounds, and mixtures thereof.

The additive is not particularly limited and may be any of those commonly known in the art. Specifically, the additive may be selected from the group consisting of crosslinkers, photoacid generators, sensitizers, thermal acid generators, surfactants, adhesion aids, heat stabilizers, photocuring accelerators, antioxidants, light stabilizers, defoamers, and mixtures thereof.

The solvent is not particularly limited and may be an organic solvent commonly known in the art. Specifically, the solvent may be selected from the group consisting of acetate-based solvents, ether-based solvents, glycol-based solvents, ketone-based solvents, alcohol-based solvents, carbonate-based solvents, and mixtures thereof.

The photoresist composition is coated on a substrate 2 to form a photoresist film 1 (step a)). The photoresist composition can be coated (or deposited) on the substrate by a suitable method generally known in the art. The substrate 2 may be made of various materials. Specifically, the substrate 2 may be a glass substrate or a plastic film.

In step b), the photoresist film 1 is patterned. Specifically, a patterned photomask 3 is placed on the photoresist film 1 and energy is applied to the photoresist film to expose the photoresist film.

Specifically, the energy applied to the photoresist film 1 may be light energy such as visible light, infrared light or ultraviolet light energy, electromagnetic energy by electromagnetic waves of various frequencies, electrical energy by current or voltage, magnetic energy by magnetic force or magnetic field or particle energy by protons, neutrons, electron beams or ion beams.

A micropattern of several hundred micrometers or less may be formed in the patterned photomask 3. A digital micromirror device may be used instead of the photomask 3.

The photoresist film 1 may be patterned by optofluidic maskless lithography (OFML) to prevent diffusion of free radicals during photoreaction and to form a high-resolution micro-scale pattern.

The method may include heating and drying to control light diffusion of free radical and acidic and basic active materials remaining in the photoresist film 1 after exposure (post-exposure baking).

In step c), the photoresist film 1 is developed to selectively remove portions of the photoresist film where photoreaction has occurred after exposure or portions of the photoresist film where no photoreaction has occurred, leaving only portions 1' of the photoresist film. The development is performed using a developer. Specifically, the developer may be an aqueous alkaline solution.

In step d), the developed photoresist film 1' is cured to form a patterned layer 1a having a plurality of tapered openings (O). The tapered openings (O) can be defined as a hole whose width gradually increases or decreases (while forming an inclined plane) in the thickness direction of the photoresist film 1 and which penetrates the photoresist film 1.

The openings (O) is attributed to the characteristics of the photoresist composition, which facilitate control over the width and/or taper angle of the openings (O) in the patterned layer of the flexible photo-patterned mask. That is, the flexible photo-patterned mask of the present invention is simply manufactured by photolithography such that the width and/or taper angle of the patterned openings are controlled. In contrast, conventional metal masks are manufactured through various complex processes, including wet etching, plating, and multiple exposure.

Inclined planes are formed in the openings (O) due to the shape of the tapered openings (O). The taper angle (θ) can be defined as the angle between the substrate 1 or the ground and the inclined plane. Here, the taper angle (θ) may be less than 90°. In consideration of the deposition efficiency of an organic light emitting material (to prevent some areas of the lower portions of the openings from being shaded by the side walls of the openings), the taper angle (θ) may be between 20° and 85° (specifically between 25° and 70°).

The curing (hard baking) of the developed photoresist film 1' in step d) is not limited to particular conditions. For example, the curing temperature may be 200 to 250 °C and the curing time may be 20 to 60 minutes.

The method of the present invention may further include repeating steps a) to d) one or more times (specifically 2 or 3 times) to form multiple patterned layers 1a, each of which has a plurality of the tapered openings (O). For example, steps a) to d) are carried out to form a first patterned layer and are then repeated to form a second patterned layer and a third patterned layer sequentially formed on the first patterned layer. Here, the photoresist compositions used in step a) to form the first to third patterned layers may be identical to or different from each other.

The method of the present invention may further include forming metal layers either or both on and under the patterned layer 1a formed in step d). A process for forming the metal layers is not particularly limited and may be specifically atomic layer deposition (ALD), thermal evaporation, electroplating or metal deposition. When the patterned layer has a multilayer structure consisting of the first patterned layer 1a, the second patterned layer 1b, and the third patterned layer 1c, the metal layers may be formed either or both on and under the outermost patterned layer.

The flexible photo-patterned mask of the present invention can provide a solution to the problem of a conventional metal mask or photomask in which vertical side walls of patterned openings shade some areas of the lower portions of the patterned openings, making it difficult to uniformly deposit an organic light emitting material. That is, the patterned openings of the flexible photo-patterned mask according to the present invention are inclined, which will be described in detail with reference to the corresponding drawings.

Referring to FIG. 3, the flexible photo-patterned mask of the present invention includes a patterned layer 1a having a plurality of the tapered openings (O). The tapered openings (O) can be defined as a hole whose width gradually increases or decreases (while forming an inclined plane) in the thickness direction of the photoresist film 1 and which penetrates the photoresist film 1.

Inclined planes are formed in the openings (O) due to the shape of the tapered openings (O). The taper angle (θ) can be defined as the angle between the ground and the inclined plane. Here, the taper angle (θ) may be less than 90°. In consideration of the deposition efficiency of an organic light emitting material (to prevent some areas of the lower portions of the openings from being shaded by the side walls of the openings), the taper angle (θ) may be between 20° and 85° (specifically between 25° and 70°).

The widths of the upper (Φ₁) and lower portions (Φ₂) of each opening (O) are in the range of 1 to 100 µm and may be different from each other (specifically, Φ₁ is preferably smaller than Φ₂ (Φ₁ < Φ₂)).

The thickness (δ) of the patterned layer 1a having the plurality of tapered openings (O) may be 1 to 100 µm, specifically 5 to 80 µm.

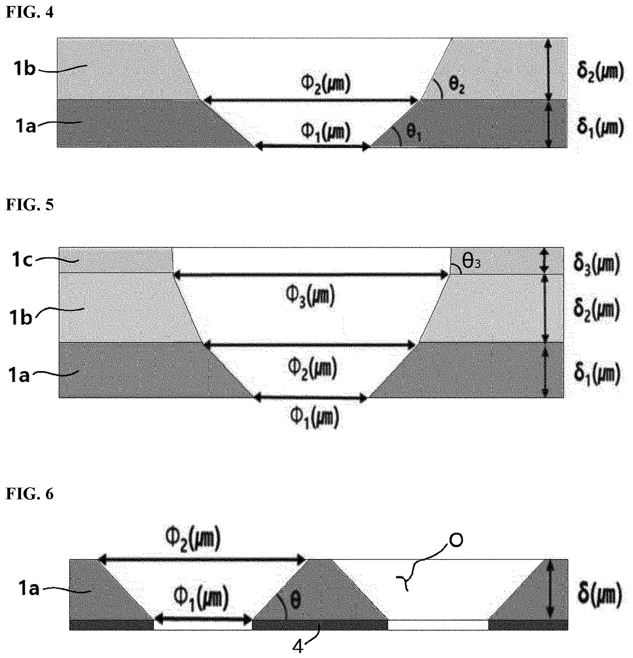

Referring to FIGS. 4 and 5, the flexible photo-patterned mask of the present invention may include a plurality of patterned layers. Specifically, the flexible photo-patterned mask of the present invention includes a first patterned layer 1a having a plurality of tapered openings, a second patterned layer 1b formed on the first patterned layer 1a, and a third patterned layer 1c formed on the second patterned layer 1b.

The taper angle (θ₁) of the tapered openings of the first patterned layer 1a may be 20° to 85°, the taper angle (θ₂) of the tapered openings of the second patterned layer 1b may be 30° to 85°, and the taper angle (θ₃) of the tapered openings of the third patterned layer 1c may be 45° to less than 90°.

The thicknesses of the first patterned layer 1a (δ₁) and the second patterned layer 1b (δ₂) may be 1 to 100 µm, specifically 5 to 80 µm. The thickness (δ₃) of the third patterned layer 1c may be 1 nm to 100 µm, specifically 1 nm to 50 µm.

When the taper angles (θ₁, θ₂, θ₃) and/or thicknesses (δ₁, δ₂, δ₃) of the first patterned layer 1a, the second patterned layer 1b, and the third patterned layer 1c are within the respective ranges defined above, shading by the side walls of the openings is minimized, resulting in high deposition efficiency of an organic light emitting material.

Considering the deposition efficiency of an organic light emitting material, it is preferable that the lower width (Φ₁) of the first patterned layer 1a, the lower width (Φ₂) of the second patterned layer 1b, and the lower width (Φ₃) of the third patterned layer 1c are within the range of 1 to 100 µm and satisfy the relationship Φ₁ < Φ₂ < Φ3.

The stack of the multiple patterned layers of the flexible photo-patterned mask according to the present invention enables control over the widths and/or the taper angles of the openings.

Referring to FIG. 6, the flexible photo-patterned mask of the present invention may further include metal layers 4 either or both on and under the patterned layer 1a. Here, when the patterned layer has a multilayer structure consisting of the first patterned layer 1a, the second patterned layer 1b, and the third patterned layer 1c, the metal layers may be formed either or both on and under the outermost patterned layer.

The metal layers 4 may have a thickness of 1 nm to 100 µm. The metal layers 4 may be formed of a metal commonly known in the art.

The formation of the metal layers 4 ensures high mechanical strength of the flexible photo-patterned mask and is effective in blocking moisture and oxygen.

The present invention also provides a method for depositing an organic light emitting material using the flexible photo-patterned mask. Specifically, the method of the present invention includes A) aligning a flexible photo-patterned mask including a patterned layer having a plurality of tapered openings on a substrate for an organic light emitting display and B) depositing an organic light emitting material on the substrate through the plurality of tapered openings, which will be described in detail with reference to the corresponding drawing.

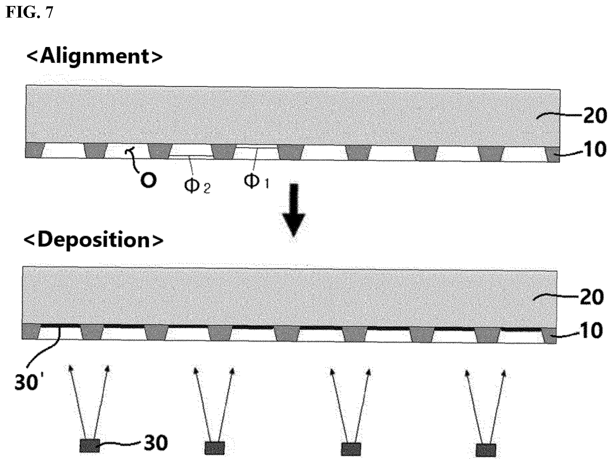

Referring to FIG. 7, first, a flexible photo-patterned mask including a patterned layer having a plurality of tapered openings (O) is aligned with a substrate (20) for an organic light emitting display before an organic light emitting material is deposited on the substrate. Here, the flexible photo-patterned mask (10) is aligned such that a smaller width (specifically the smallest width) of the tapered openings (O) faces the substrate (20). That is, the tapered openings (O) become smaller in width as they approach the substrate (20) (Φ₁ < Φ₂).

The use of the flexible photo-patterned mask (10) having openings (O) whose width (Φ) and taper angle (θ) are controlled minimizes shading by the side walls of the openings to increase the deposition efficiency of an organic light emitting material, enabling the fabrication of an organic light emitting display with high resolution and improved pixel uniformity.

Next, an organic light emitting material (30) is deposited on the substrate (20) through the plurality of tapered openings (O). The deposition may be performed by a suitable method commonly known in the art. As a result of the deposition, an array of pixels (areas (30') where the organic light emitting material is deposited) can be formed on the substrate (10).

The substrate (20) may be any of those commonly known in the art (*e.g.,* a glass substrate or a flexible substrate such as a polyimide substrate).

The organic light emitting material can be efficiently deposited on pixel areas through the tapered openings (O), enabling the fabrication of an organic light emitting display with high resolution and improved pixel uniformity.

The present invention will be more specifically explained with reference to the following examples. However, these examples are provided for illustrative purposes only and the scope of the present invention is not limited thereto. It will be evident to those skilled in the art that various modifications and changes can be made without departing from the scope and spirit of the present invention.

### [Example 1]

7.5 g of a resin (Takoma, TSR-SB5K), 0.7 g of a photoinitiator (Takoma, TPM-P370), 2.1 g of a photocurable material (DPHA), 0.05 g of an adhesion aid (KBM403), 0.1 g of a surfactant (FZ2122), and 10.5 g of a solvent (PGMEA) were mixed to prepare a negative type photoresist composition. The photoresist composition was spin-coated on a glass substrate to form a 12 µm thick photoresist film. Then, a photomask having a pattern (size 1-50 µm) was placed on the photoresist film. The photoresist film was exposed to an ultra-high pressure mercury lamp and developed in a spray type with a 0.04% potassium hydroxide solution as a developer at 23 °C for 60 sec. Next, the developed photoresist film was hard baked at 250 °C for 60 min to manufacture a flexible photo-patterned mask including a patterned layer (thickness 10 µm) having a plurality of tapered openings (taper angle 40°).

### [Example 2]

7.5 g of a resin (Takoma, TSR-SB10K), 3 g of a photoactive material (a diazonaphthoquinone compound), 5 g of a solvent (PGMEA), 0.15 g of an adhesion aid (KBM403), and 0.2 g of a surfactant (FZ2122) were mixed to prepare a positive type photoresist composition. The photoresist composition was spin-coated and pre-baked on a glass substrate to form a 12 µm thick photoresist film. Then, a photomask having a pattern (size 1-50 µm) was placed on the photoresist film. The photoresist film was exposed to an ultra-high pressure mercury lamp and developed in a spray type with a 2.38% TMAH as a developer at 23 °C for 60 sec. Next, the developed photoresist film was hard baked at 250 °C for 60 min to manufacture a flexible photo-patterned mask including a patterned layer (thickness 10 µm) having a plurality of tapered openings (taper angle 50°).

### [Example 3]

Each of the flexible photo-patterned masks manufactured in Examples 1 and 2 was aligned on a glass substrate such that the smallest width of the openings (O) of the patterned layer faced the substrate. Then, an organic light emitting material was vacuum-deposited on the glass substrate through the openings of the patterned layer.

## Claims

1. A method for manufacturing a flexible photo-patterned mask, comprising a) coating a photoresist composition on a substrate to form a photoresist film, b) exposing the photoresist film to pattern the photoresist film, c) developing the patterned photoresist film, and d) curing the developed photoresist film to form a patterned layer having a plurality of tapered openings.

2. The method according to claim 1, wherein the photoresist composition is a positive type one comprising: at least one resin selected from the group consisting of acrylic resins, imide resins, cardo resins, and silicone resins; a photoactive material; an additive; and a solvent.

3. The method according to claim 1, wherein the photoresist composition is a negative type one comprising: at least one resin selected from the group consisting of acrylic resins, imide resins, cardo resins, and silicone resins; a photocurable material; a photoinitiator; an additive; and a solvent.

4. The method according to claim 1, further comprising repeating steps a) to d) one or more times to form a plurality of patterned layers, each of which has a plurality of tapered openings.

5. The method according to claim 1, further comprising forming metal layers either or both on and under the patterned layer.

6. The method according to claim 1, wherein the tapered openings have a taper angle (θ) of 20° to 85°.

7. A flexible photo-patterned mask comprising a patterned layer having a plurality of tapered openings.

8. The flexible photo-patterned mask according to claim 7, wherein the tapered openings have a taper angle (θ) of 20° to 85°.

9. The flexible photo-patterned mask according to claim 7, wherein the patterned layer is provided in plurality.

10. The flexible photo-patterned mask according to claim 7, wherein the patterned layer comprises a first patterned layer having tapered openings and a second patterned layer having tapered openings, the tapered openings of the first patterned layer have a taper angle (θ₁) of 20° to 85°, and the tapered openings of the second patterned layer have a taper angle (θ₂) of 30° to 85°.

11. The flexible photo-patterned mask according to claim 7, wherein the patterned layer comprises a first patterned layer having tapered openings, a second patterned layer having tapered openings, and a third patterned layer having tapered openings, the tapered openings of the first patterned layer have a taper angle (θ₁) of 20° to 85°, the tapered openings of the second patterned layer have a taper angle (θ₂) of 30° to 85°, and the tapered openings of the third patterned layer have a taper angle (θ₃) of 45° to 90°.

12. The flexible photo-patterned mask according to claim 7, further comprising metal layers formed either or both on and under the patterned layer.

13. A method for depositing an organic light emitting material, comprising A) aligning a flexible photo-patterned mask comprising a patterned layer having a plurality of tapered openings on a substrate for an organic light emitting display and B) depositing an organic light emitting material on the substrate through the plurality of tapered openings wherein the plurality of tapered openings become smaller in width as they approach the substrate.
